# EUROPEAN PATENT APPLICATION

(11) **EP 0 772 233 A1**
(43) Date of publication of application: **07.05.1997**
(21) Application number: 96410110.9
(22) Date of filing: 25.10.1996
(51) Int. Cl.: H01L 23/498, H01L 23/055

(54) **A solder ball array package**

(30) Priority: 30.10.1995 FR 9513045
(71) Applicant: SGS-THOMSON MICROELECTRONICS S.A., 94250 Gentilly (FR)
(72) Inventor: Saboui, Ali Reza, SGS-Thomson Microelectronics SA, 13106 Rousset Cedex (FR)
(74) Representative: de Beaumont, Michel

(57) **Abstract**

The present invention concerns an integrated circuit package (90) that comprises an integrated circuit (100) that is fixed to a substrate (110) having, on a side opposite to the side on which the integrated circuit is fixed, a plurality of surface mount solder pads (125) for receiving solder balls (135) that are connected to bond pads (115) on the active side (B) of the integrated circuit. The substrate is fixed to the active side of the integrated circuit and does not go beyond the edges of the active side.

## Description

The present invention relates to packaging for semiconductor devices, and more particularly to ball grid array packages.

A leadless solder ball array package is disclosed in U.S. Pat. No. 5,241,133 MULLEN, III et al. and a method of making such a package by transfer moulding is disclosed in U.S. Pat. No. 5,218,759 Juskey et al.

Leadless packages, also commonly known as ball grid array (BGA) packages, have been introduced and developed over recent years. These BGA packages have become popular primarily due to their high connection densities and low profiles.

However, one problem associated with these BGA packages of, and similar to, the types as described in the aforementioned U.S. patents is that their surface areas are large. Another problem surrounds the dissipation of heat from these BGA packages.

The range of surface area of these BGA packages is from approximately 7 millimetres square to 50 millimetres square with the most common size being typically 27x27=729 square millimetres.

Typically, the maximum area of an integrated circuit that can be accommodated on a 27x27 BGA package is 15x15=225 square millimetres. Therefore, for a 15 millimetre square integrated circuit within a 27 millimetre square BGA package, approximately 70% of the BGA package area is around the periphery of an attached integrated circuit. In other words, when the integrated circuit is attached to the substrate of the BGA package, i.e. the printed circuit board (p.c.b.), it occupies only approximately 30% of the total area of the BGA package; the other 70% being used for routing the connections, vias, bond pads, solder ball pads etc.

To help with heat dissipation, there are now emerging power BGA packages that utilise various types of heat slugs to which the integrated circuit is mechanically, and sometimes electrically, attached. The heat slug is mechanically attached to the substrate, i.e. the p.c.b., of the BGA package: the substrate having a suitable aperture through which the integrated circuit is passed. The integrated circuit is then electrically bonded to the p.c.b. substrate, which can be either a single layer or a multilayer p.c.b.

BGA packages are relatively expensive to produce because of the cost of producing the p.c.b. substrate, especially the multilayer power BGA p.c.b. substrate.

Furthermore, there is also a significant amount of non-recyclable waste p.c.b. that results from current handling methods of p.c.b. BGA substrate strips. These strips, which are typically 1x6 strips of BGA substrates, have guide rails and holes surrounding each individual BGA substrate. In the case of a power BGA substrate, which has an aperture, the waste is even more significant.

An object of the present invention is to provide a particularly small ball grid array package.

Another object of the present invention is to provide such a ball grid array package that has a low thermal impedance.

In order to achieve these objects and overcome the problems associated with the prior art, the present invention proposes a integrated circuit solder ball array package that comprises an integrated circuit that is mechanically fixed to a leadless supporting insulating substrate having, on a side opposite to the side on which the integrated circuit is fixed, a plurality of surface mount solder pads, for receiving solder balls, that are connected to bond pads on the active side of the integrated circuit. The substrate is fixed to the active side of the integrated circuit and does not go beyond the edges of the active side, i.e. the area of the substrate is no bigger than that of the integrated circuit.

According to another embodiment of the present invention, the integrated circuit's bond pads are placed around the periphery of the integrated circuit and are not covered by the substrate that also comprises bond pads, which are on the solder ball side of the substrate, that are electrically connected by bond wires to the integrated circuit's bond pads.

According to another embodiment of the present invention, a protective plastic material envelopes the sides of the substrate and the bond wires, leaving exposed the solder pads and balls and an inactive side of the integrated circuit that is opposite to its active side.

According to another embodiment of the present invention, the protective material envelopes the sides of the integrated circuit and does not go beyond the plane of the inactive side.

According to another embodiment of the present invention, the substrate comprises at least two laminated substrate layers, the first being connected to the integrated circuit and comprising the substrate's bond pads, the second, which does not cover the substrate's bond pads, comprising the solder pads and solder balls.

According to another embodiment of the present invention, the protective material envelopes the sides of the substrate and the bond wires and does not go beyond the plane of the solder pads.

These objects as well as other features and advantages of the present invention will be exposed in detail in the following description of the particular embodiments that are intended to be non-limiting with relation to the attached figures amongst which:
Figure 1 illustrates a cross sectional view of an embodiment of a ball grid array package according to the present invention;
Figure 2 illustrates a cross sectional view of another embodiment of a ball grid array package according to the present invention;
Figure 3 illustrates a cross sectional view of a third embodiment of a ball grid array package according to the present invention; and
Figure 4 illustrates a bottom-up view of the ball grid array package of Figure 3.

The figures which illustrate the various embodiments of the present invention incorporate the same or similar elements. Therefore, where the same or similar elements appear throughout the various figures, they will be designated in the same manner.

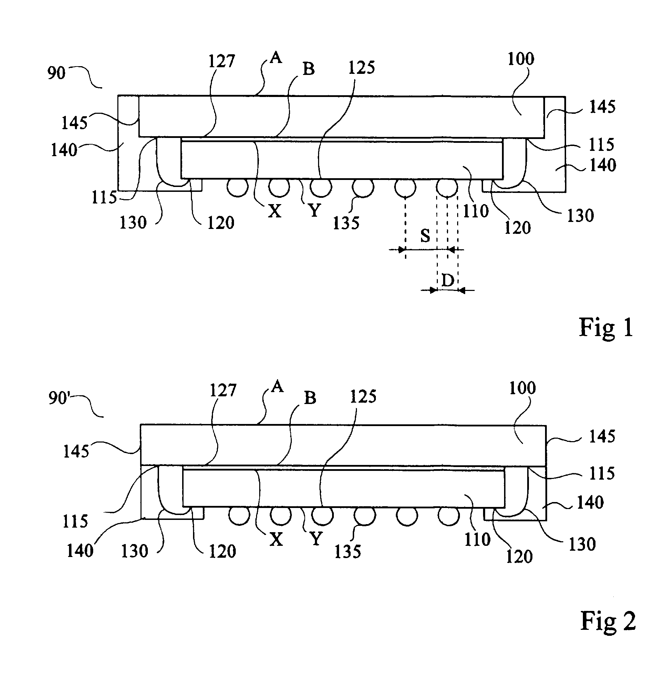

In Figure 1 a ball grid array (BGA) package 90 comprises two main elements: an integrated circuit 100 and a printed circuit board (p.c.b.) substrate 110. According to the present invention the p.c.b. substrate 110 is substantially the same size as the integrated circuit, or chip. A BGA package according to the present invention is thus "chip size".

The integrated circuit 100 and the p.c.b. 110 each have two substantially planar sides respectively A, B and X, Y.

Side A is the inactive side of the circuit 100 and side B is its active side. Side B is active in the sense that it is the side through which all electrical connections with the outside world are to be made: side B includes the integrated circuit's bond pads 115.

Side X is the inactive side of the p.c.b. 110 and side Y is its active side. Side Y is active in the sense that it is the side through which all electrical connections are made with the integrated circuit 100 and the outside world. Side Y includes all the p.c.b.'s bond pads 120, solder ball pads 125 and operative connections (not illustrated) between them.

Side X of the p.c.b. is mechanically attached, by means of a non-conductive adhesive 127, to side B of the circuit. The p.c.b. 110 is dimensioned and then positioned on the circuit 100 such that it rests within the inner periphery of the circuit's bond pads 115. In other words the p.c.b. is dimensioned and then positioned such that it does not cover any of the circuit's bond pads 115.

Bond wires 130 are attached between the respective bond pads 115 and 120 of the circuit 100 and the p.c.b. 110 for making the appropriate electrical connections between the circuit 100 and p.c.b. 110. The aforementioned operative connections of the p.c.b. electrically connect the bond pads 120 of the p.c.b., and hence those 115 of the circuit 100, to the solder ball pads 125. Attached to the solder ball pads 125 are the solder balls 135.

The spacing S between the centres of the solder balls is currently between approximately 1.0-1.3 millimetres and the diameter D of the solder balls is between approximately 400-650 micrometers. Therefore, using such dimensions S and D the BGA package according to the present invention can be made compatible with current JEDEC standards on the testing of wire bonded integrated circuits.

Nevertheless, the applicant believes that with future developments in this technological field, it will one day be possible to test, to JEDEC wire bond standards, BGA packages whose solder balls have a spacing between them of S<0.5 millimetres and diameters D<200 micrometers. Therefore, once this technology matures the present invention will be able to offer a chip size BGA that has an even greater number of inputs/outputs, i.e. solder balls 135.

The circuit bond pads 115, the p.c.b. bond pads 120 and the bond wires 130 are protected from mechanical and electrical damage by a plastic based material 140. In this embodiment the protective material 140 is illustrated as covering the bond pads and wires, enveloping the edges 145 of the circuit 100 and being substantially flush with side A. It is preferable to ensure that the protective material 140 is either flush with side A or set just below side A so that a thermal dissipater or can be attached directly to side A. Attaching a heat sink directly to side A of the circuit 100 is most effective in dissipating heat away from the circuit 100.

Another advantage of this chip size ball grid array is that it is very thin, since no protective material is necessary on side A of circuit 100.

Figure 2 illustrates a cross sectional view of another embodiment of a chip size ball grid array package according to the present invention. The ball grid array package 90' is substantially the same as that of Figure 1 except that in this embodiment the protective material 140 does not envelope the edges 145 of the circuit 100. Instead, the protective material 140 is substantially in the same plane, i.e. is flush with, the edges 145 of the circuit 100.

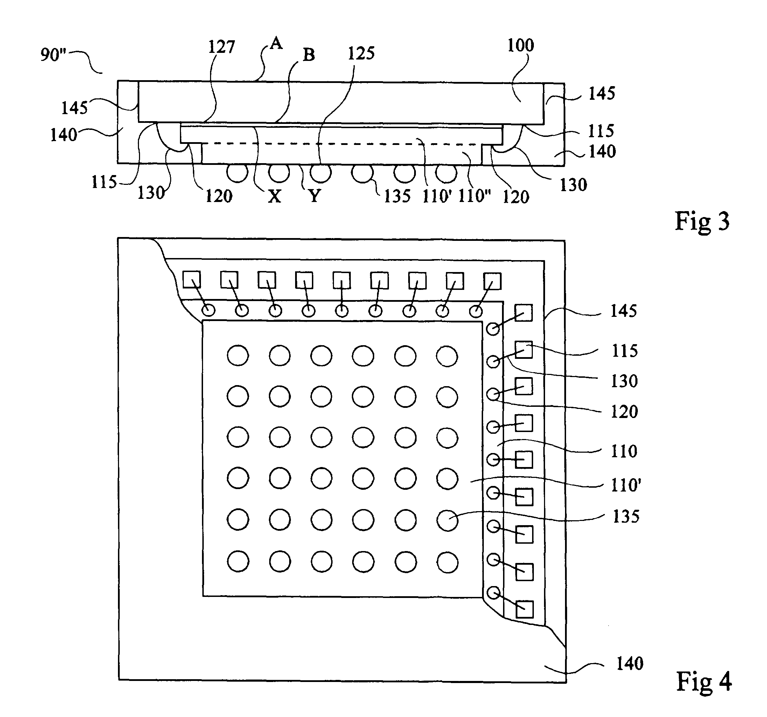

Figures 3 and 4, illustrate a cross sectional view and a bottom-up view of a third embodiment of a chip size ball grid array package according to the present invention. The ball grid array package 90" is substantially the same as that of Figure 1 except that in this particular embodiment the p.c.b. 110 is a multilayer p.c.b. that includes first and second laminated layers 110', 110". The multilayer p.c.b. can conceivably include three or more appropriately laminated layers.

The first layer 110' is similar to the p.c.b. layer 110 in Figure 1. The wire bonds 130 are attached to the pads 120 this layer 110' as before.

The second layer 110" is dimensioned and then positioned on the first layer 110' such that it rests within the inner periphery of the first layer's bond pads 120. In other words the second layer p.c.b. 110" is dimensioned and then positioned such that it does not cover any of the first layer's bond pads 120. This second layer 110" is provided with solder ball pads 125 and has suitable electrical connections (not illustrated), through vias, between the pads 125 and the first layer 110'.

Although this invention has been described in connection with certain preferred embodiments, it should be understood that the present disclosure is to be considered as an exemplification of the principles of the invention and that there is no intention of limiting the invention to the disclosed embodiments. On the contrary, it is intended that all alternatives, modifications and equivalent arrangements as may be included within the spirit and scope of the appended claims be covered as part of this invention.

## Claims

1. An integrated circuit package (90, 90', 90") that comprises an integrated circuit (100) that is fixed with its active side (B) to a leadless supporting insulating substrate (110) having, on a side opposite to the side on which the integrated circuit is fixed, a plurality of surface mount solder pads (125) for receiving solder balls (135) that are connected to bond pads (115) of the active side (B), characterised in that the substrate does not go beyond the edges of the active side.

2. An integrated circuit package according to claim 1, characterised in that the integrated circuit's bond pads (115) are placed around the periphery of the integrated circuit and are not covered by the substrate (110) that comprises bond pads (120), which are on the solder ball side of the substrate, that are connected by bond wires (130) to the integrated circuit's bond pads (115).

3. An integrated circuit package according to claim 1, characterised in that a protective material (140) envelopes the sides of the substrate (110) and the bond wires (130) leaving exposed the solder pads (125) and solder balls (135) and an inactive side (A) of the integrated circuit that is opposite to the active side (B).

4. An integrated circuit package according to claim 3, characterised in that the protective material (140) envelopes the sides of the integrated circuit (100) and does not go beyond the inactive side (A).

5. An integrated circuit package according to claim 2, characterised in that the substrate comprises at least two layers, the first (110') being connected to the integrated circuit (100) and comprising the substrate's bond pads (120), the second, which does not cover the substrate's bond pads (120), comprising the solder pads (125) and solder balls (135).

6. An integrated circuit package according to claim 5, characterised in that the protective material (140) envelopes the sides of the substrate (110) and the bond wires (130) and does not go beyond the plane of the solder pads (125).
